# EUROPEAN PATENT APPLICATION

(11) **EP 2 944 867 A1**
(43) Date of publication of application: **18.11.2015**
(21) Application number: 14193892.8
(22) Date of filing: 19.11.2014
(51) Int. Cl.: F21V 11/16, H01L 33/58, H01L 33/60, F21W 131/103

(54) **Light emitting module and lighting apparatus having the same**

(30) Priority: 12.05.2014 KR 20140056327
(71) Applicant: LG Electronics Inc., Yeongdeungpo-gu Seoul 150-721 (KR)
(72) Inventor: Jeong, Seoyoung, 153-802 Seoul (KR); Kim, Sangman, 153-802 Seoul (KR); Kim, Yongjin, 153-802 Seoul (KR)
(74) Representative: Ter Meer Steinmeister & Partner

(57) **Abstract**

Provided is a light emitting module. The light emitting module includes a board unit (23), a light source unit (24) mounted on the board unit (23), a diffusion lens (27) disposed above the light source unit (24) to diffuse light emitted from the light source unit (24), and a shield member (25) disposed independent from the diffusion lens (27) under the diffusion lens (27) to prevent the light emitted from the light source unit (24) from being irradiated in a specific direction.

## Description

### BACKGROUND

The present disclosure relates to a light emitting module and a lighting apparatus having the same.

Lighting apparatuses may be electric appliances that are used for lighting a specific space. Incandescent lamps, discharge lamps, fluorescent lamps, and the like may be widely used as light sources for the lightings. Resistive light sources such as the incandescent lamps may have relatively low efficiency and relatively high heat generation. On the other hand, the discharge lamps may be expensive and have relatively high voltages. Also, the fluorescent lamps may have environmental problems due to use of mercury (Hg).

To solve the above-described limitations in the light sources according to the related art, there is a growing interest in lighting apparatuses using light emitting diodes (LEDs) that have various advantages in efficiency, color diversity, and design autonomy. Thus, various types of LED lighting apparatus are being released.

Such an LED may be a semiconductor device that emits light when a forward voltage is applied. The LED may have a long life-cycle, low power consumption, and electrical, optical, and physical properties that are adequate for mass production. In recent years, the LEDs are being spotlighted as lighting units that are substituted with the incandescent lamps and the fluorescent lamps.

Also, the LED light sources may be quickly applied to lighting apparatuses such as streetlamps, safety lights, park lights, or security lights.

The lighting apparatuses such as streetlamps or safety lights may be mainly hung on a column member. Also, the lighting apparatuses have to emit light at an optimum angle according to surrounding environments. For example, in the case of the streetlights which are installed in the periphery of an agricultural land in which fruit trees or crops are grown, if light is irradiated onto the crops, the light may have caused enormous troubles to the growth of the crops. In addition, sufficient light may not be irradiated onto a road along which pedestrians are walking to cause inconvenience in walking. Thus, it may be preferable that the most light emitted from such a lighting apparatus is irradiated onto the road, and an amount of light irradiated onto the crops is minimized.

Also, in the case of the streetlamps installed in alleys of residential streets, if light is irradiated onto windows of houses, residents inhabited in the corresponding house may be interrupted in deep sleep. Thus, it may be preferable that the light of the streetlamps is minimally irradiated onto the residential streets, and the light is maximally irradiated onto the alleys.

However, the general lighting apparatuses according to the related art may uniformly irradiate light downward in all directions. Thus, it may be difficult to control light irradiation in a specific direction. Particularly, the light emitted from the lighting apparatus may be irradiated into an unnecessary region to cause above-described problems. In addition, the intensity of illumination may be reduced in a region in which lighting is required, and thus an original aim of the lighting apparatus may not be sufficiently achieved.

### <Reference document>

Korean Patent Publication No. 2012-0130472.

### SUMMARY

The present disclosure is proposed to improve the above-described limitations.

In one embodiment, a light emitting module includes: a board unit; a light source unit mounted on the board unit; a diffusion lens disposed above the light source unit to diffuse light emitted from the light source unit; and a shield member disposed independent from the diffusion lens under the diffusion lens to prevent the light emitted from the light source unit from being irradiated in a specific direction.

In another embodiment, a lighting apparatus includes: a housing; a light emitting module mounted on one surface of the housing; and a control box mounted on one side of the housing, the control box including a control unit for electrically controlling the light emitting module, wherein the light emitting module includes: a board unit; a light source unit mounted on the board unit; a diffusion lens disposed above the light source unit to diffuse light emitted from the light source unit; and a shield member disposed independent from the diffusion lens under the diffusion lens to prevent the light emitted from the light source unit from being irradiated in a specific direction.

The light emitting module may be provided in plurality, and the plurality of light emitting modules may be arranged adjacent to the housing, and the control unit may independently control on/off operations of the plurality of light emitting modules.

The details of one or more embodiments are set forth in the accompanying drawings and the description below. Other features will be apparent from the description and drawings, and from the claims.

### BRIEF DESCRIPTION OF THE DRAWINGS

Fig. 1 is a perspective view of a lighting apparatus including a shield member according to an embodiment.
Fig. 2 is a perspective view of a light emitting module including a shield member according to an embodiment.
Fig. 3 is an exploded perspective view of the light emitting module.
Fig. 4 is a front perspective view of a state in which a light source unit and a shield part are mounted on a board unit according to an embodiment.
Fig. 5 is a back perspective view of the light source unit and the shield part.
Fig. 6 is a cross-sectional view taken along line I-I' of Fig. 3.
Fig. 7 is a cross-sectional view of a state in which the shield member is mounted on the board unit according to an embodiment.
Fig. 8 is a cross-sectional view of a state in which a shield member is mounted on a board unit according to another embodiment.
Fig. 9 is a cross-sectional view of a state in which a shield member is mounted on a board unit according to further another embodiment.
Fig. 10 is a cross-sectional view of a state in which a shield member is mounted on a board unit according to further another embodiment.
Fig. 11 is a cross-sectional view of a state in which a shield member is mounted on a board unit according to further another embodiment.
Fig. 12 is a cross-sectional view of a state in which a shield member is mounted on a board unit according to further another embodiment.

### DETAILED DESCRIPTION OF THE EMBODIMENTS

Hereinafter, a light emitting module and a lighting apparatus including the same according to embodiments will be described in detail with reference to the accompanying drawings.

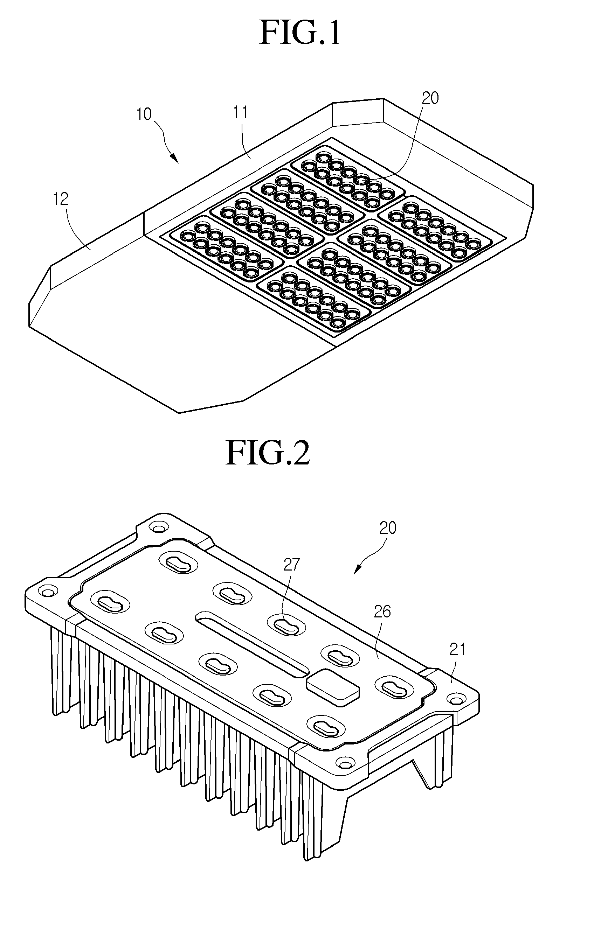

Fig. 1 is a perspective view of a lighting apparatus including a shield member according to an embodiment.

Referring to Fig. 1, a lighting apparatus 10 according to an embodiment may include a housing 11, a plurality of light emitting modules 20 that are arranged adjacent to one surface of the housing 11, and a control box 12 mounted on the housing 11. Also, a control unit for electrically controlling the plurality of light emitting modules 20 may be disposed within the control box 12. The control unit may control turn-on/off operations of the plurality of light emitting modules 20 at the same time or independently control a turn-on/off operation of each of the plurality of light emitting modules 20.

Although a plurality of light emitting devices may be provided as the light emitting modules, and the plurality of light emitting modules are mounted on the lighting apparatus in the current embodiment, the present disclosure is not limited thereto. That is, the ideas of the present disclosure may be applied to all lighting apparatuses for irradiating light in a specific direction.

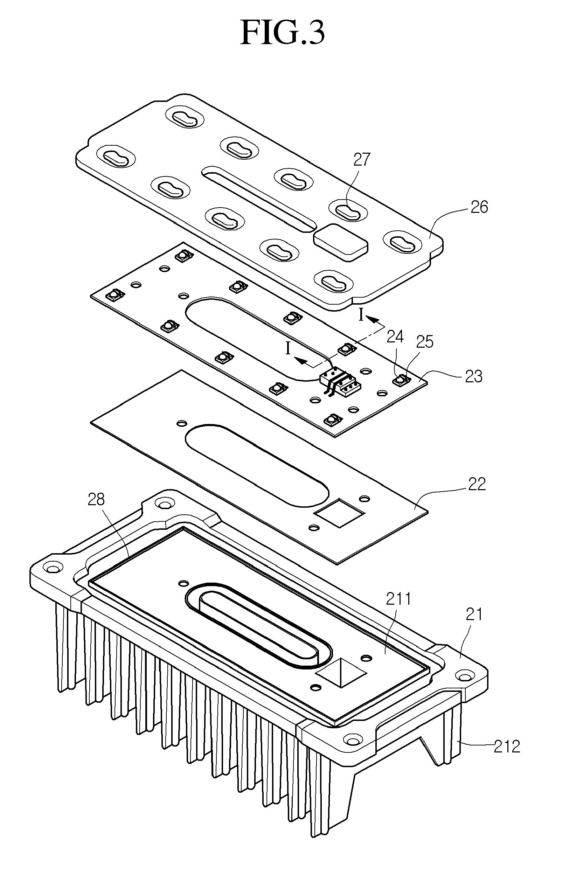

Fig. 2 is a perspective view of a light emitting module including a shield member according to an embodiment, and Fig. 3 is an exploded perspective view of the light emitting module.

Referring to Figs. 2 and 3, the light emitting module 20 including a shield member according to an embodiment includes a heatsink 21 for releasing heat, a heat dissipating pad 22 disposed on a top surface of the heatsink 21, a board unit 23 disposed on a top surface of the heat dissipating pad 22, a plurality of light source units 24 mounted on the board unit 23, a shield member 25 seated on a side of each of the plurality of light source units 24 to prevent light emitted from the light source units 24 from being diffused in a specific direction, a cover plate 26 disposed above the light source units 24, and a diffusion lens 27 disposed in the cover plate at a position corresponding to each of the light source units 24.

In detail, the heatsink 21 may be a heat dissipating unit for releasing heat generated from the light source units 24 to the outside. Thus, the heatsink 21 may be formed of an aluminum material having superior heat dissipating properties. Also, a seat unit 211 on which the members including the heat dissipating pad 22, the board unit 23, the light source units 24, the shield member 25, and the cover plate 26 are seated may be stepped at a predetermined depth on one surface of the heatsink 21. A plurality of heat dissipating fins 212 may protrude from the other surface of the heatsink 21. The plurality of heatsink fins 212 may be spaced a predetermined distance from each other and heat-exchanged with air flowing therebetween.

Also, a sealing member 28 may be disposed on an edge of the seat unit 211 to surround the seat unit 211. The sealing member 28 may contact the cover plate 26 to prevent moisture and foreign substances including dusts from being introduced into the light source units 24.

Also, the heat dissipating pad 22 may be a heat dissipating plate disposed between the board unit 23 and the seat unit 211. Alternatively, the heat dissipating pad 22 may not be provided according to the light emitting module 20.

The cover plate 26 may be a member for covering the light source units 24 and the shield member 25 to protect the light source units 24 and the shield member 25. In detail, a plurality of through holes may be defined inside the cover plate 26, and the diffusion lens 27 may be mounted in each of the through holes. According to another embodiment, the diffusion lens 27 and the cover plate 26 may be integrated as one body and provided as transparent plates formed of the same material.

The diffusion lens 27 may be a diffusion unit for diffusing light emitted from the light source units 24. The diffusion lens 27 may irradiate a more amount of light in a specific direction or uniformly irradiate light in all directions according to a geometrical shape thereof.

In detail, the diffusion lens 27 may be injection-molded by using one polymer resin of polyethyeleneterepthalate (PET), polycarbonate (PC), polypropylene (PP), polyethylene (PE), polystyrene (PS), polyepoxy (PE), and polymethylmethacrylate, (PMMA).

Also, the diffusion lens 27 may have a dome shape that is rounded in a convex shape. Alternatively, the diffusion lens 27 may have spherical or aspherical shape according to a design condition that is based on light diffusion properties. Alternatively, the diffusion lens 27 may have a symmetrical or asymmetrical shape with respect to a vertical plane. Also, light emitted from the light source units 24 may be refracted while passing through the diffusion lens 27 to realize luminous intensity distribution having a specific shape. That is, the diffusion lens 27 may form a light distribution curve so that a relatively large amount of light is irradiated in a specific direction according to the geometrical shape and thickness thereof.

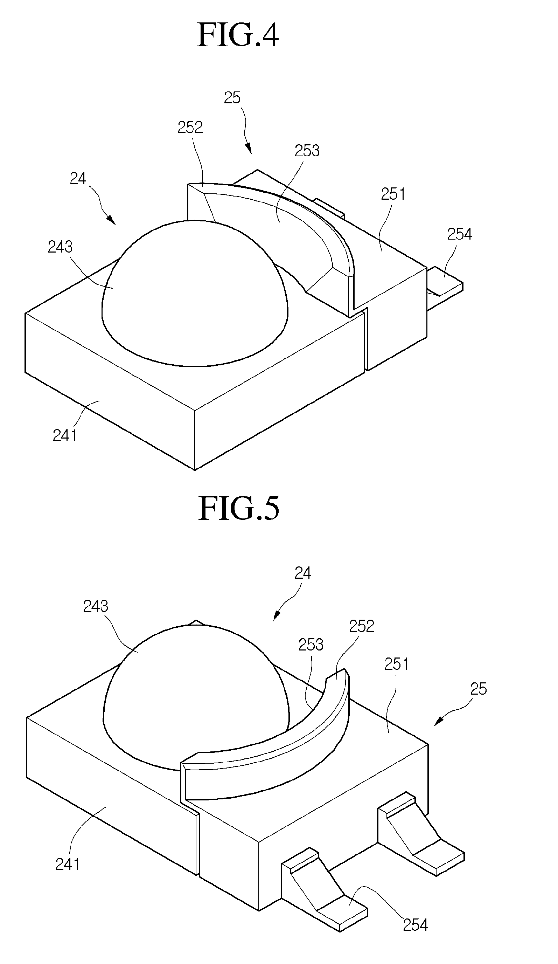

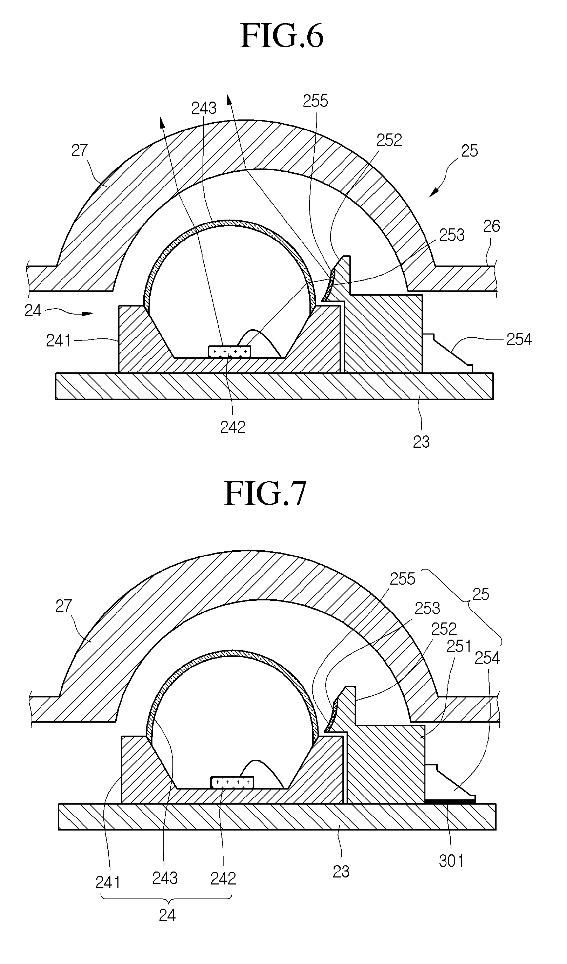

Fig. 4 is a front perspective view of a state in which a light source unit and a shield part are mounted on a board unit according to an embodiment, Fig. 5 is a back perspective view of the light source unit and the shield part, and Fig. 6 is a cross-sectional view taken along line I-I' of Fig. 3.

Referring to FIGS. 4 to 6, each of the light source units 24 according to an embodiment may use a chip-on-board LED that is directly mounted on the board unit 23 or a surface mount device LED as a light source. In the current embodiment, the surface mount device LED may be described as an example.

In detail, the light source unit 24 may include a sub mount board 241 disposed on a board, a light emitting device 242 including an LED chip mounted on a top surface of the sub mount board 241, and an encapsulant 243 covering the light emitting device 242.

In more detail, the light emitting device 242 may be a blue light emitting diode. The encapsulant 243 may have a hemispherical lens shape and be seated on the sub mount board 241. Also, a yellow phosphor may be applied to an inner circumferential surface of the encapsulant 243 to emit white light from the light source unit 24. Here, the encapsulant 243 may have a hemispherical shape filled with a transparent resin in which a phosphor is mixed.

An air layer is formed between the encapsulant 243 and a bottom surface of the diffusion lens 27. The light emitted from the light emitting device 242 may be primarily refracted while passing through the encapsulant 243. Also, the light may be secondarily refracted while passing through the diffusion lens 27. Then, the light refracted by passing through the diffusion lens 27 may be diffused in multi directions. Also, a more mount of light may be refracted and diffused in a specific direction according to the shape of the diffusion lens 27. In addition, the diffusion lens 27 may vary in thickness according to points at which light emitted from the light emitting device 242 collides to change a refraction angle, thereby diffusing a more amount of light in a specific direction.

The shield member 25 may absorb or reflect a portion of the light emitted from the light source unit 24 to prevent the light from being diffused in a specific direction.

In detail, the shield member 25 may include a body part 251, a shield part 252 protruding from a side of the body part 251 and having a shield surface 253 on one surface thereof, and a fixed part 254 disposed on the other side of the body part 251.

The shield member 25 may be molded by using engineering plastic having superior heat resistance and including polyacetal (POM), polyamide (PA), polycarbonate (PC), modified polyphenylene ether (m-PPE), or liquid polymer (LCP).

Also, a shield layer 255 for reflecting or absorbing the light emitted from the light source unit 24 may be disposed on the shield surface 253.

In detail, the shield layer 255 may be a reflection layer for reflecting the light emitted from the light source unit 24 in an opposite direction. Also, the reflection layer may include a reflection sheet containing a metal or metal oxide having high reflectivity such as aluminum, silver, nickel, chrome, gold, or titanium dioxide. Also, the reflection layer may be formed by performing a deposition or coating process on the shield surface 253. Alternatively, metal ink may be printed on the shield surface 253 to form the reflection layer.

Also, the deposition method may include a physical vapor deposition (PVD) method or vacuum evaporation method including a thermal evaporation method, an evaporation method, or a sputtering method. The coating or printing method may include a printing method, a gravure coating method, or a silk screen method.

As illustrated in the drawings, the shield surface 253 may have a shape that is rounded at a predetermined curvature along a shape of the encapsulant 243 on the outside of the light source unit 24. However, the present disclosure is not limited thereto. For example, the shield surface 253 may have a polygonal shape in which a plurality of planes each of which has a narrow width are successively connected to each other along the shape of the encapsulant 243.

Also, the reflection layer may include a white reflection sheet (or white reflection film) formed of a white polyethylene-terephthalate having specular reflection and diffuse reflection properties.

Also, the shield member 25 may be formed of engineering plastic using terephthalic acid (TPA) having a white color in itself to reflect the light emitted from the light source unit 24.

The shield layer 255 may be a light absorption layer or optical absorption layer that is capable of absorbing the light emitted from the light source unit 24. For example, the shield layer 255 may include a black film sheet that is attached, printed, or applied to the shield surface 253. Alternatively, the shield layer 255 may be formed by depositing metal chalcogenide light absorption material on the shield surface 253. Of cause, the shield member 25 may be an engineering plastic member including the light absorption material in itself. For example, the shield member 25 may be an injection-molded product that is molded by using a black resin.

If the shield layer 225 includes the light absorption layer that is capable of absorbing light, luminous efficiency may be reduced when compared to that in a case in which light is reflected in a direction in which lighting is required. However, in aspect of the shielding for preventing light from being irradiated into a region in which the light is unnecessary, the shield layer may have the same effect as the reflection layer.

Fig. 7 is a cross-sectional view of a state in which the shield member is mounted on the board unit according to an embodiment.

Referring to Fig. 7, the shield member 25 may include the body part 251 and the fixed part 254 as described above.

In detail, the body part 251 may be formed engineering plastic having high heat resistance. The fixed part 254 may be formed of a solderable metal material. For example, the fixed part 254 may include a metal lead frame that is capable of being surface-mounted. Also, the body part 251 and the fixed part 254 may be integrated with each other through double injection molding. Also, the fixed part 254 may be welded to a top surface of the board unit 23 to form a welding part 301 between the fixed part 254 and the board part 23. Thus, since the shield member 25 may also be surface-mounted on a side of the light source unit 24 in the process for surface-mounting the light source unit 24 on the board unit 23, the light source unit 24 and the shield member 25 may be directly attached to the board unit 23 through a single process.

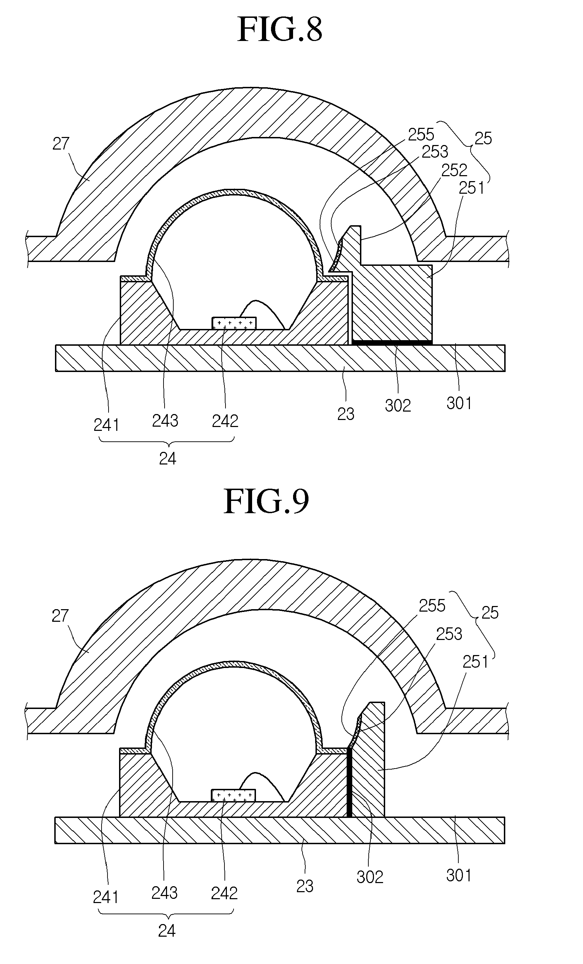

Fig. 8 is a cross-sectional view of a state in which a shield member is mounted on a board unit according to another embodiment.

Referring to Fig. 8, a shield member 25 according to another embodiment may be provided as a single engineering plastic injection product without providing a fixed part 254 formed of a metal material. Also, an adhesion layer 302 may be disposed on a bottom part of the shield member 25 to bond the shield member 25 to the top surface of the board unit 23. Here, the adhesion layer 302 may include an adhesive having a high heat resistance property including a polybenzimida zoles (PBI) adhesive, a polyimide (PI) adhesive, a phenol resin adhesive, and an epoxy resin adhesive or a double-sided adhesion tape.

Fig. 9 is a cross-sectional view of a state in which a blocking member is mounted on a substrate part according to further another embodiment.

Referring to Fig. 9, a shield member 25 may be provided to a side of a light source unit 24 as a separate member. Particularly, the shield member 25 may be attached to an adhesion layer 320 on a side surface of a sub mount board 214 constituting the light source unit 24.

That is, the current embodiment is different from the foregoing embodiment in that the shield member 25 is not attached to the board unit 23, but is bonded to the sub mount board 241 by using an adhesive. Also, since the shield member 25 is attached to the sub mount board 241, a structure of the fixed part 254 may be unnecessary. Thus, a shield surface 253 may be defined on one side surface of a body part 251 of the shield member 25, particularly, on a surface facing the light source unit 24. Also, the shield layer 255 may be disposed on the shield surface 253.

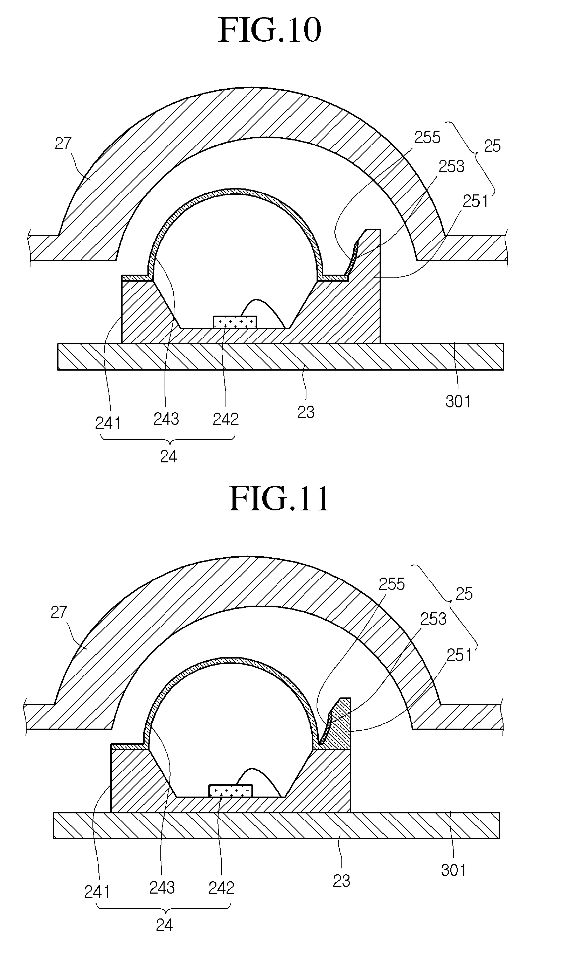

Fig. 10 is a cross-sectional view of a state in which a blocking member is mounted on a substrate part according to further another embodiment.

Referring to Fig. 10, a shield member 25 and a sub mount board 241 of a light source unit 24 may be provided as one body.

In detail, when the sub mount board 241 is manufactured, the shield member 25 may be molded at the same time. That is, a body part 251 may protrude from one side surface of the sub mount board 241, and a shield surface 253 may be defined on a side surface of the body unit 251 toward an encapsulant 243. Thus, a shield layer 255 may be disposed on the shield surface 253. In the current embodiment, the shield member 25 including the body part 251 may constitute a portion of the sub mount board 241.

Fig. 11 is a cross-sectional view of a state in which a blocking member is mounted on a substrate part according to further another embodiment.

Referring to Fig. 11, a shield member 25 and an encapsulant 243 constituting a light source unit 24 may be provided as one body.

In detail, while the encapsulant 243 is injection-molded, the shield member 25 may be integrated with one side edge of the encapsulant 243. Also, the shield member 25 may include a body part 251 extending upward from an edge of the encapsulant 243, a shield surface 253 disposed on a side surface of the body part 251 toward the encapsulant 243, and a shield layer 255 disposed on the shield surface 253. According to the above-described structure, the encapsulant 243 may perform a proper function of the encapsulant 243 and also perform a function of the shield part 251 for preventing light from being diffused in a specific direction. In the current embodiment, the shield member 25 may constitute a portion of the encapsulant 243.

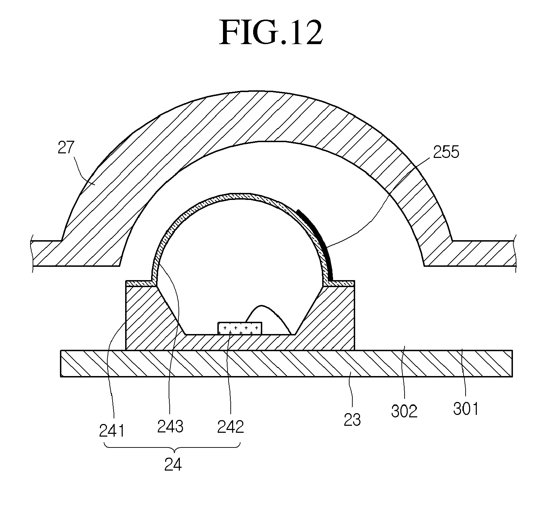

Fig. 12 is a cross-sectional view of a state in which a blocking member is mounted on a substrate part according to further another embodiment.

Referring to Fig. 12, a shield layer 255 according to further another embodiment may be directly disposed on an inner or outer circumferential surface of an encapsulant 243.

In detail, the shield layer 255 may be directly disposed on a surface of the encapsulant 243 in addition to the method in which the shield member is separately disposed on the side of the light source unit 24 as described in the foregoing embodiment. Thus, light irradiated from a light emitting device 242 toward the shield layer 255 may be absorbed or re-reflected by the shield layer 255.

Also, the shield layer 255 may be a reflection sheet containing a metal or metal oxide including at least one of aluminum, silver, nickel, chrome, gold, or titanium dioxide to specular-reflect the light emitted from the light emitting device 242 as described in the foregoing embodiments.

Alternatively, the shield layer 255 may be a white reflection sheet that is formed of a PET material and specular-reflects and diffusion-reflects the light emitted from the light emitting device 242.

Also, the shield layer 255 may be deposited, applied, or printed on a surface of the encapsulant 243.

The shield layer may be a black film sheet that is attached, printed, or applied to the surface of the encapsulant 243 to absorb the light emitted from the light emitting device 242.

As described above, since the shield layer 255 is directly disposed on the surface of the encapsulant 243, it may be unnecessary to separately install the shield member 25, thereby reducing manufacturing costs.

The light emitting module including the above-described constitutions and the lighting apparatus having the same according to the embodiments may have following effects.

First, it may prevent the light emitted from the light source from being irradiated in a specific direction to prevent the light from being irradiated in an unnecessary direction.

Second, the light irradiated in a specific direction may be reflected to the necessary region to prevent the light from being irradiated in an unnecessary direction, thereby improving the intensity of illumination in the region in which the lighting is required.

Third, it may be unnecessary to separately install a shield wall in the periphery of the lighting apparatus so as to prevent the light from being irradiated into the region which the lighting is unnecessary.

Fourth, in the lighting apparatus according to the embodiments, the shield member for absorbing or reflecting the light emitted from the light source to prevent the light from being irradiated in a specific direction may be directly mounted on the board unit on which the light emitting device is mounted. In addition, the shield member may be mounted while the mounting of the light emitting device is performed.

Thus, since it is unnecessary to separately stack the board including the shield member for preventing the light from being irradiated in a specific direction on the light source, the lighting apparatus may achieve the desired purpose without increasing in total thickness, thereby realizing miniaturization of the lighting apparatus.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting module comprising:
a board unit;
a light source unit mounted on the board unit;
a diffusion lens disposed above the light source unit to diffuse light emitted from the light source unit; and
a shield member disposed independent from the diffusion lens under the diffusion lens to prevent the light emitted from the light source unit from being irradiated in a specific direction.

2. The light emitting module according to claim 1, wherein the light source unit comprises:
a light emitting device comprising an LED chip; and
an encapsulant having a hemispherical shape to surround a top surface of the light emitting device.

3. The light emitting module according to claim 2, wherein the shield member comprises:
a body part; and
a shield part protruding from one side of the body part, the shield part comprising a shield surface defined to face the light source unit.

4. The light emitting module according to claim 3, wherein the shield surface is rounded at a predetermined curvature along the outside of the encapsulant or has a polygonal shape in which planes each of which has a narrow width are successively connected to each other along the outside of the encapsulant.

5. The light emitting module according to claim 3, wherein the shield member is molded by using engineering plastic comprising one of polyacetal (POM), polyamide (PA), polycarbonate (PC), modified polyphenylene ether (m-PPE), or liquid polymer (LCP).

6. The light emitting module according to claim 3, further comprising a shield layer disposed on the shield surface to reflect the light emitted from the light source unit.

7. The light emitting module according to claim 6, wherein the shield layer comprises one sheet of a reflection sheet containing a metal or metal oxide comprising at least one of aluminum, silver, nickel, chrome, gold, or titanium dioxide to specular-reflect the light emitted from the light source unit and a white reflection sheet that is formed of a polyethyeleneterepthalate (PET) material and specular-reflects and diffusion-reflects the light emitted from the light source unit,
wherein the shield layer is deposited, applied, or printed on the shield surface.

8. The light emitting module according to claim 6, wherein the shield layer comprises a light absorption layer that is formed of a light absorption material to absorb the light emitted from the light source unit and is attached, deposited, printed, or applied to the shield surface.

9. The light emitting module according to claim 1, wherein the shield member comprises a white engineering plastic member containing a terephthalic acid (TPA) to reflect and diffuse the light emitted from the light source unit or an engineering plastic member containing a light absorption material to absorb the light emitted from the light source unit.

10. The light emitting module according to claim 6, further comprising an adhesion layer disposed on a bottom surface of the body part to bond the body part to the board unit.

11. The light emitting module according to claim 6, wherein the shield member further comprises a metal fixed part which is fixed to the body part through double injection molding on the other side of the body part,
wherein a bottom surface of the metal fixed part is soldered to a top surface of the board unit.

12. The light emitting module according to claim 6, wherein the light source unit further comprises a sub mount board on which the light emitting device is seated, and
the body part is attached to a side surface of the sub mount board.

13. The light emitting module according to claim 6, wherein the light source unit further comprises a sub mount board on which the light emitting device is seated, and
the body part constitutes a portion of the sub mount board.

14. The light emitting module according to claim 2, wherein the shield member comprises:
a body part constituting a portion of the encapsulant and extending upward from an edge of the encapsulant;
a shield surface disposed on a side surface of the body part toward the encapsulant; and
a shield layer disposed on the shield surface to absorb or re-reflect a portion of the light emitted from the light emitting device.

15. The light emitting module according to claim 2, wherein the shield member is disposed on a portion of an inner or outer circumferential surface of the encapsulant to absorb or re-reflect at least one portion of the light from the light emitting device in the specific direction.

16. The light emitting module according to claim 15, wherein the shield layer comprises one sheet of a reflection sheet containing a metal or metal oxide comprising at least one of aluminum, silver, nickel, chrome, gold, or titanium dioxide to specular-reflect the light emitted from the light emitting device and a white reflection sheet that is formed of a PET material and specular-reflects and diffusion-reflects the light emitted from the light emitting device.

17. The light emitting module according to claim 15, wherein the shield layer is deposited, applied, or printed on a surface of the encapsulant.

18. The light emitting module according to claim 15, wherein the shield layer comprises a black film sheet that is attached, printed, or applied to a surface of the encapsulant to absorb the light emitted from the light emitting device.

19. A lighting apparatus comprising:
a housing;
a light emitting module mounted on one surface of the housing; and
a control box mounted on one side of the housing, the control box comprising a control unit for electrically controlling the light emitting module,
wherein the light emitting module comprises:
a board unit;
a light source unit mounted on the board unit;
a diffusion lens disposed above the light source unit to diffuse light emitted from the light source unit; and
a shield member disposed independent from the diffusion lens under the diffusion lens to prevent the light emitted from the light source unit from being irradiated in a specific direction.

20. The lighting apparatus according to claim 19, wherein the light emitting module is provided in plurality, and the plurality of light emitting modules are arranged adjacent to the housing, and
the control unit independently controls on/off operations of the plurality of light emitting modules.
